# EUROPEAN PATENT SPECIFICATION

(11) **EP 1 424 885 B1**
(45) Date of publication and mention of the grant of the patent: **23.11.2011**
(21) Application number: 03027478.1
(22) Date of filing: 01.12.2003
(51) Int. Cl.: H05K 13/04

(54) **Electronic component mounting apparatus and electronic component mounting method**
Elektronische Bauteile-Bestückungsvorrichtung und Methode
Appareil de montage de composants électroniques et méthode

(30) Priority: 29.11.2002 JP 2002347716
(43) Date of publication of application: 02.06.2004
(73) Proprietor: Hitachi High-Tech Instruments Co., Ltd., Ora-gun, Gunma-ken, 370-0596 (JP)
(72) Inventor: Oyama, Kazuyoshi, Ashikaga-shi Tochigi (JP); Fukushima, Hideaki, Ora-gun Gunma (JP)
(74) Representative: Glawe, Delfs, Moll

(56) References cited:
- EP-A- 0 994 328
- US-A- 5 787 577
- US-B1- 6 211 958
- US-B1- 6 285 782

## Description

### BACKGROUND OF THE INVENTION

### Field of the Invention

The invention relates to an electronic component mounting apparatus and a method for mounting electronic components on a printed board including picking the electronic components up from component feeding units by suction nozzles, taking images of the electronic components by a component recognition camera while illuminating the components by an illumination device, and performing recognition processing by a recognition processing device.

### Description of the Related Art

A conventional electronic component mounting method is disclosed in, for example, a Japanese Patent Application Publication No. 2000-136904. Generally, even when component library data having feature data of electronic components and so on are carefully formed, there are not many cases where component recognition processing is properly performed in practice, because of a mismatch between the components and an optical system or an illumination system. In a conventional electronic component mounting apparatus, a maintenance environment for the component recognition processing is executed independently before the mounting operation, and an informing and confirming environment is prepared in a menu of the maintenance environment.

In this environment, component library informing and a component recognition test are performed. However, both are performed using real electronic components which are picked up (including a real component picked up by hand), and the components are collected after completing the library informing and the recognition test. This causes wasting of real components. Furthermore, it requires many loads, and it is actually difficult to check whether or not recognition can be properly performed for all components to be used, in the maintenance environment before operation in order to successfully set the mounting apparatus up for the operation.

Furthermore, although a mounting operation is being successfully performed initially, there often occurs a case where picked-up components are continuously recognized as improper. This is because of a difference of outer sizes which is caused by a lot difference or a manufacturer difference of the components supplied, and because the illuminating conditions are improper for the components because of a color difference in molded portions of the components.

Therefore, it is an object of this invention to provide an apparatus and method allowing a timely and immediate adjustment operation in order to reduce time wasting for a halt of the mounting apparatus and to achieve a flexible operation to adjust to changes in working circumstances.

### SUMMARY OF THE INVENTION

The solution according to the invention lies in the features of the independent claims and preferably in those of the dependent claims.

The invention provides an electronic component mounting apparatus mounting electronic components on a printed board. The apparatus includes a plurality of component feeding units feeding the electronic components, a suction nozzle picking up one of the electronic components from the component feeding units, an illumination device illuminating the electronic component picked up by the suction nozzle, a component recognition camera taking an image of the illuminated electronic component, a recognition processing device performing a recognition processing of the image of the electronic component taken by the component recognition camera, and an image display device. The apparatus also includes a control device which requires the display to display the image of the electronic component taken by the component recognition camera when the electronic component is recognized to be improper based on a recognition processing result provided by the recognition processing device, changes an illuminating condition of the illumination devices based on an instruction of an operator monitoring the displayed image, requires the component recognition camera to take another image of the electronic component picked up by the suction nozzle for another recognition processing under the changed illuminating condition, and mounts the electronic component on the printed board when the electronic component is recognized to be proper after said another recognition processing. The control device may modify component library data of the electronic component based on an instruction of an operator monitoring the displayed image and use the modified data for the recognition processing.

The invention also provides a method for mounting an electronic component. The method includes picking up the electronic component from a component feeding unit by a suction nozzle, illuminating the electronic component picked up by the suction nozzle, taking an image of the illuminated electronic component by a component recognition camera, displaying the image taken by the component recognition camera when the electronic component is recognized to be improper based on a recognition processing performed on the image taken by the component recognition camera, changing an illuminating condition based on a decision by an operator monitoring the displayed image, and mounting the electronic component on a print board when the electronic component picked up by the suction nozzle is recognized to be proper based on another recognition processing performed under the changed illumination condition. The method may include modifying component library data of the electronic component in response to a decision by an operator monitoring the displayed image and performing the recognition processing under the modified data.

Accordingly, the invention achieves to prevent setting errors of illuminating conditions by performing a component recognition test and component library informing for first real components picked up from component feeding units in a case where the components are recognized as improper before mounting on a first printed board after the mounting apparatus is set for a new type of printed board.

### BRIEF DESCRIPTION OF THE DRAWINGS

Fig. 1 is a plan view of an electronic component mounting apparatus of an embodiment of the invention.
Fig. 2 is a cross-sectional view along line B-B of Fig. 1.
Fig. 3 is a block diagram showing controlling the electronic component mounting apparatus of the embodiment.
Fig. 4 shows an operation screen for a "component recognition monitoring navigation mode setting" of the embodiment.
Fig. 5 shows an operation screen for a "specified lane monitoring mode setting" of the embodiment.
Fig. 6 shows a structure of component library data of the embodiment.
Fig. 7 shows a structure of component library data including original data and temporary data of the embodiment.
Fig. 8 shows illumination data of the embodiment.
Fig. 9 is a cross-sectional view showing an illumination device of the embodiment.
Fig. 10 is an operation screen for an illuminating condition adjustment setting of the embodiment.
Figs. 11A and 11B are screens showing a flowchart of the embodiment.

### DETAILED DESCRIPTION OF THE INVENTION

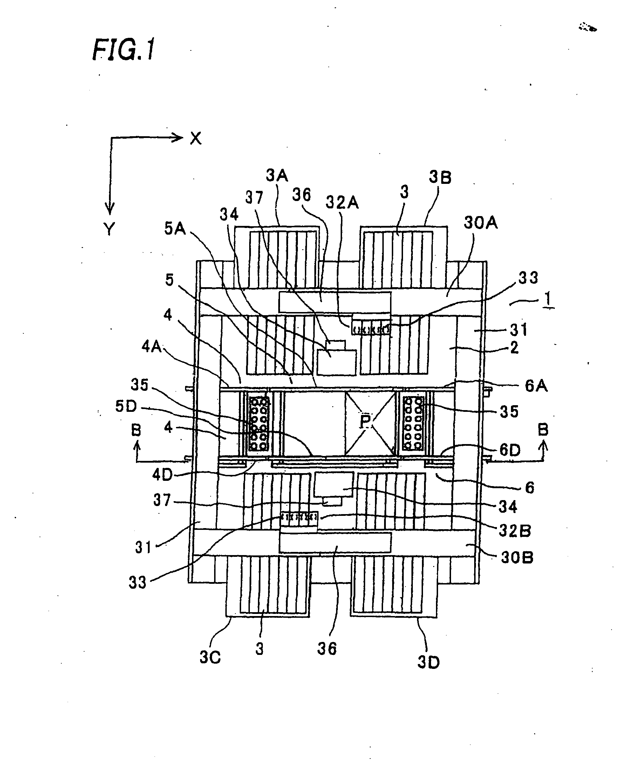

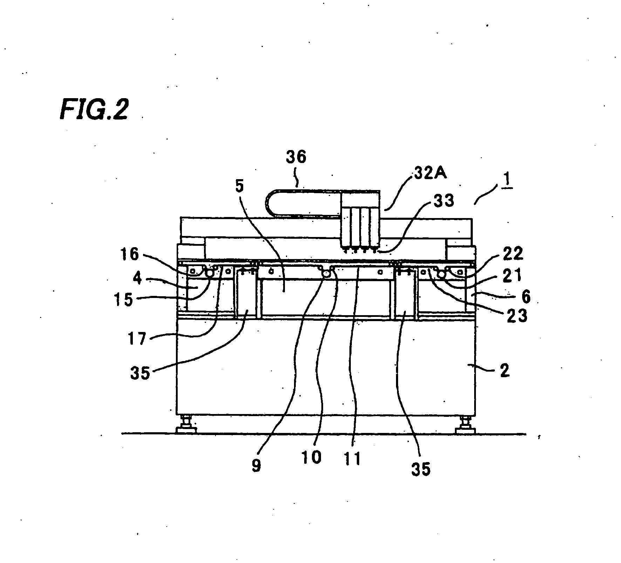

An embodiment of the invention will be described with reference to the drawings. Fig. 1 is a plan view of an electronic component mounting apparatus 1, and Fig. 2 is a cross-sectional view along line B-B of Fig. 1. A plurality of component feeding units 3 is detachably aligned and fixed on feeder bases 3A, 3B, 3C, and 3D on a base 2 of the electronic component mounting apparatus 1, and each of the component feeding units 3 feeds each of various electronic components to its component feeding position (component pick-up position) one by one.

A feed conveyer 4, a positioning portion 5, and a discharge conveyer 6 are provided on the base 2 between groups of the component feeding units 3 facing to each other. The feed conveyer 4 conveys a printed board P received from an upstream device (not shown) to the positioning portion 5, an electronic component is mounted on the printed board P positioned by a positioning device (not shown) in the positioning portion 5, and the printed board P is conveyed to the discharge conveyer 6 and then to a downstream device (not shown).

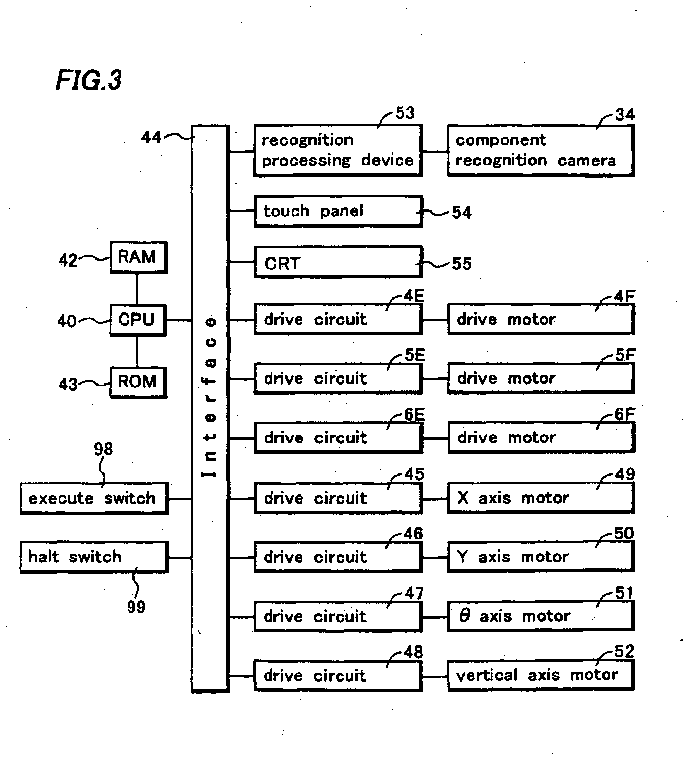

A convey belt 11 is provided on a stationary chute 5A and a movable chute 5D of the positioning portion 5 for conveying the printed board P, being stretched between a drive roller 9 and a plurality of rollers 10 which rotate driven by a drive motor 5F through a drive circuit 5E of Fig. 3 as shown in Fig. 2.

A convey belt 17 is provided on a stationary chute 4A and a movable chute 4D of the feed conveyer 4 for conveying the printed board P, being stretched between a drive roller 15 and a plurality of rollers 16 which rotate driven by a drive motor 4F through a drive circuit 4E of Fig.3 as shown in Fig. 2.

A convey belt 23 is provided on a stationary chute 6A and a movable chute 6D of the discharge conveyer 6 for conveying the printed board P, being stretched between a drive roller 21 and a plurality of rollers 22 which rotate driven by a drive motor 6F through a drive circuit 6E of Fig. 3 as shown in Fig. 2.

Numerals 30A and 30B designate a pair of beams extending in an X direction. By rotation of a screw axis driven by a Y axis motor 50, each of the beams 30A and 30B moves in a Y direction above the printed board P fixed on the positioning portion 5 and the component feeding positions (component pick-up positions) of the component feeding units 3 along a pair of left and right guides 31.

The beams 30A and 30B are provided with mounting heads 32A and 32B respectively which move in a longitudinal direction, i.e., in the X direction along guides driven by an X axis motor 49. Each of the mounting heads 32A and 32 B is mounted with a vertical axis motor 52 for vertically moving four suction nozzles 33, and mounted with a θ axis motor 51 for rotating the suction nozzles 33 around a vertical axis.

Therefore, the four nozzles 33 of each of the mounting heads 32A and 32B are movable in the X and Y directions, rotatable around the vertical axis, and vertically movable.

Numerals 34 designate component recognition cameras for recognizing a component position. There are two component recognition cameras 34 each of which is provided for the mounting heads 32A and 32B. The component recognition camera 34 takes an image of the electronic component to recognize a shift amount of a position of the electronic component held by the suction nozzle 33 from a proper position by evaluating the position in the X and Y directions and at a rotation angle.

Numerals 35 designate nozzle storage portions for storing various suction nozzles 13 for replacing the suction nozzles 33.

Flat cables 36 are formed by aligning and gluing cables and air tubes for the mounting heads 32A and 32B into a flat plate shape. Each ends of the flat cables are connected to each motors and other ends of the flat cables are connected to a control circuit board (not shown) or an air supply source (not shown).

In Fig. 3, a numeral 40 designates a CPU (mounting control portion) of microcomputer as a control portion for controlling the mounting apparatus 1. The CPU 40 is connected with a RAM (random access memory) 42 and a ROM (read only memory) 43 through bus lines. The CPU 40 controls all operations for component mounting of the electronic component mounting apparatus 1 according to programs stored in the ROM 43 based on data stored in the RAM 42.

That is, the CPU 40 controls driving of the drive motors 4F, 5F, and 6F through an interface 44 and the drive circuits 4E, 5E, and 6E, and driving of the X axis motor 49, the Y axis motor 50, the θ axis motor 51, and the vertical axis motor 52 through the interface 44 and drive circuits 45, 46, 47, and 48.

The RAM 42 stores mounting data on component mounting which includes values in the X and Y directions (indicated by X and Y respectively) and at an angle (indicated by Z) on the printed board, alignment numbers of the component feeding units 3 (indicated by FDR), and so on in order of component mounting (in order of step number). Furthermore, the RAM 42 stores component disposition data which include types of the electronic components (component ID) corresponding to alignment numbers of the component feeding units 3. Furthermore, the RAM 42 is stored with component library data having feature data of the electronic components, which will be described below. That is, the component library data on component size is stored for each of types of the components, including, for example, "shape data" or "recognition data" as described below.

A numeral 53 designates a recognition processing device connected to the CPU 40 through the interface 44. The recognition processing device 53 performs recognition processing of an image taken by the component recognition camera 34 based on the component library data and a processing result is sent to the CPU 40. That is, the CPU 40 outputs a command of performing recognition processing (i.e., calculating the shift amount of a component position) of the image taken by the component recognition camera 34 to the recognition processing device 53, and receives the recognition processing result from the recognition processing device 53.

A numeral 54 designates a touch panel attached to a screen of the CRT 55 using fixtures (not shown). The touch panel 54 is made of a glass substrate which is coated with a transparent conductive film on its whole surface and printed with electrodes on its four edges. When an operator touches the surface of the touch panel 54 in a state where minimal electric currents flow on the surface of the touch panel 54, current flows change at the four electrodes and coordinates of a touched position are calculated by a circuit board connected with the electrodes. If the calculated coordinates correspond to one of coordinates originally stored in the RAM 42 as a switch for executing a certain operation, the operation is executed. In this embodiment, portions enclosed in double boxes on the screens displayed on the CRT 55 are stored as switch portions.

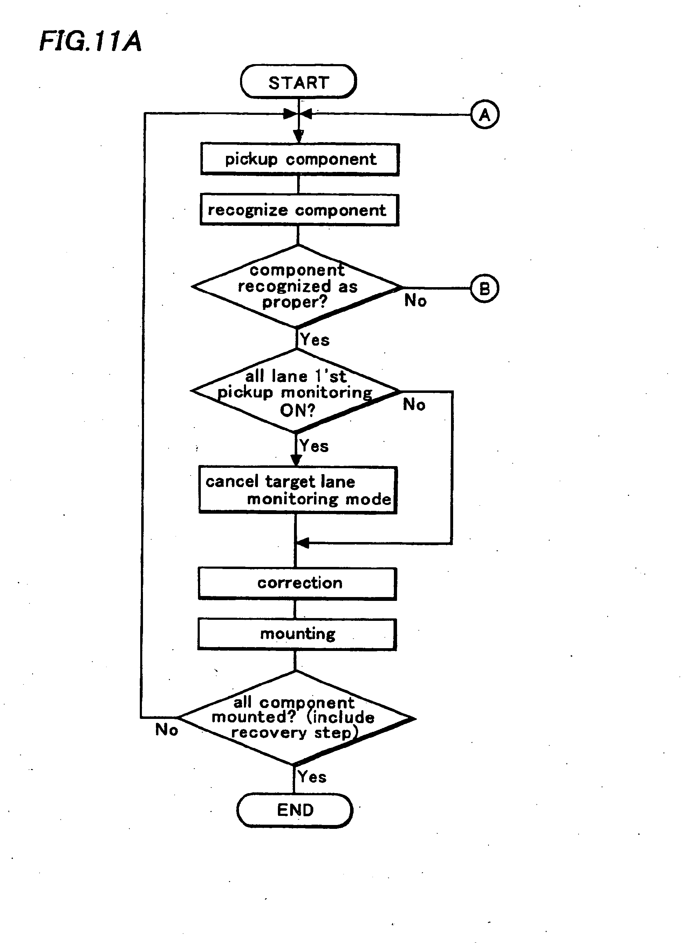

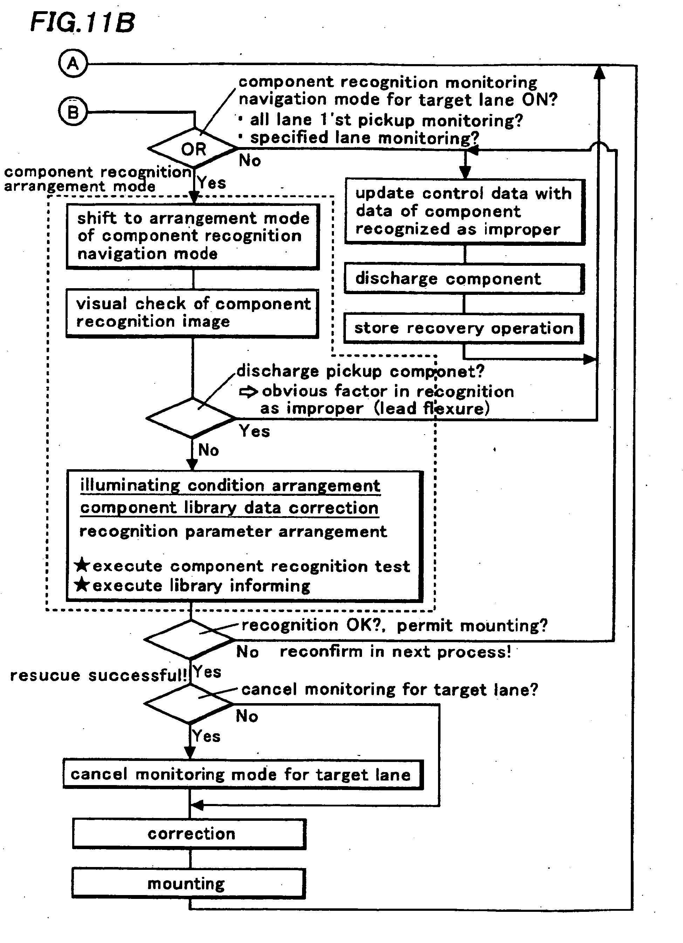

A setting method of a "component recognition monitoring navigation mode" will be described hereafter, refereeing to Figs. 11A and 11B. The "component recognition monitoring navigation mode" is for assisting a setup of the component mounting apparatus 1 by preparing following settings in order to prevent discarding a properly picked-up electronic component in an exhaust box (not shown) as an improper component by improper recognition caused by setting errors of conditions in the component recognition processing.

First, an "all lane 1'st pickup monitoring mode" will be described. This monitoring mode is targeted to first electronic components to be mounted on a first printed board P by the component mounting apparatus 1 after the apparatus 1 is set up for manufacturing printed boards of new type. In this monitoring mode, among the first electronic components which are picked up by the suction nozzles 33 from all the lanes (component feeding units 3) and recognized by the recognition processing device 53, the components which are recognized as improper are not discharged automatically but used for a component recognition test and informing and adjustment operations of a component library (recognition data).

The "all lane 1'st pickup monitoring mode" continues until each of the first components from each of the component feeding units 3 is recognized as proper by automatic operation. The "all lane 1'st pickup monitoring mode" is cancelled for the electronic component recognized as proper at a first picking-up operation from the component feeding unit 3. For the electronic component recognized as improper at the first picking-up operation, even if it is recognized as proper after an adjustment operation under recognition environment described later, the "all lane 1'st pickup monitoring mode" is not cancelled until a next picked-up component is recognized as proper. Furthermore, in an adjustment environment for a component recognized as improper at the first picking-up operation, when an operator recognizes the component as a defective component (for example, lead flexure), the component is automatically discharged by an operator's command, and the "all lane 1'st pickup monitoring mode" continues.

The cancellation of the "all lane 1'st pickup monitoring mode" at the time when the picked-up component is recognized as proper by automatic operation is for preventing the apparatus 1 from failing to establish its essential performance (i.e., to reach a maximum processing speed) because of a control of the "navigation mode" operation (i.e., specially added processing). This embodiment focuses on maintenance operation during the initial setting up of the apparatus 1 to establish stable manufacturing operation over various operation phases.

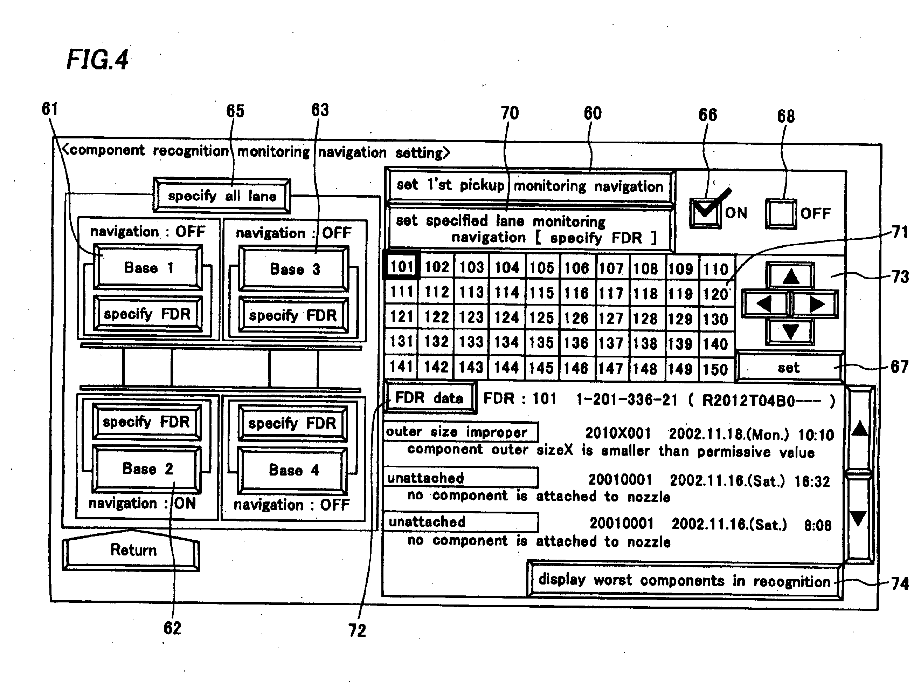

A setting of the "all lane 1'st pickup monitoring mode" in the "component recognition monitoring navigation mode" will be described hereafter. The "all lane 1'st pickup monitoring mode" is set when a new type of printed board is selected, i.e., the apparatus 1 is set to start manufacturing different printed boards. An operator selects a "manufacturing running navigation function" and then selects one of the functions, i.e., the "component recognition monitoring navigation mode setting" by operating the touch panel 54. Then, an operation screen shown in Fig. 4 is displayed on the CRT 55.

In this screen, the operator touches a "set 1'st pickup monitoring navigation" switch 60 on a right upper side for setting the "1'st pickup all lane monitoring mode", and then selects feeder bases to be set. In this example, all the component feeding units 3 on the feeder bases 3A and 3B are specified by touching a "base 1" switch 61 and a "base 2" switch 62. For specifying all the component feeding units 3 on all the feeder bases, a "select all lanes" switch 65 is to be selected.

In this state, the operator touches an "ON" switch 66 on a right upper side of the screen, and a check mark is displayed there. The operator reviews the selected items and touches a "set" switch 67. Then, "navigation: ON" is displayed at the feeder base which is set with "1'st pickup monitoring navigation". The "navigation: ON" display shows that there exist the component feeding units 3 which are set with the "monitoring navigation" in the feeder bases 3A and 3B, including a "specified lane monitoring mode" described later.

For cancellation of the "1'st pickup monitoring navigation", the operator selects switches to be cancelled among "base" switches 61, 62, 63, and 64, touches an "OFF" switch 68, and then touches a "set" switch 67.

Next, the "specified lane monitoring mode" will be described. This mode is for setting a monitoring mode for the specified lanes. For example, it is possible to specify the lanes supplied with components for filling shortage thereof or specify the lanes feeding components recognized as improper (worst components) based on control data calculated while running.

Similarly to the "all lane 1'st pickup monitoring mode", the "specified lane monitoring mode" can be cancelled at the time when the component is certainly recognized as proper by automatic operation, or can be continued when the operator decides that the operation need be monitored, until the operator commands the CPU to cancel the mode.

Next, a setting operation of the "specified lane monitoring mode" will be described hereafter. The operator touches a "set specified lane monitoring navigation mode [specify FDR]" switch 70 on a right upper side of the screen and then touches switches to be set among "FDR No." switches 71.

Then, the selected FDR number is displayed on a right side of a "FDR data" switch 72. Each of the "FDR No." switches 71 is colored based on a predetermined manner. For example, a switch colored in green means a lane for manufacturing running and in an OFF state of the monitoring navigation setting, yellow means a lane for manufacturing running and in an ON state of the monitoring navigation setting, and uncolored means a lane unused for manufacturing running.

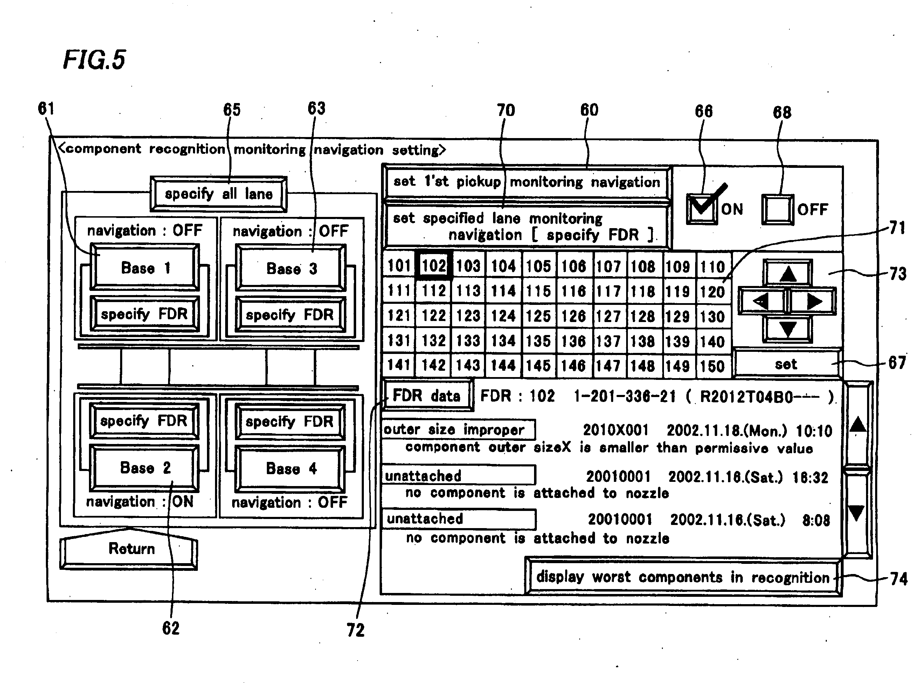

Cursor keys 73 indicating four directions are operated to move a cursor so that the "FDR number" switches 71 of the target lanes can be selected by this operation. An ID of the target component and a latest history of the target component recognized as improper are displayed as data of the component of the selected FDR number on a right lower side of Fig. 5. All the history for the target component can be seen even in a small display space by scrolling.

When the operator touches a "display worst components in recognition" switch 74, a list of the FDR numbers and the component IDs sorted in order of higher rate of the components recognized as improper among the components to be used for manufacturing running is displayed. This can be referred for selecting lanes to be set with the monitoring navigation mode.

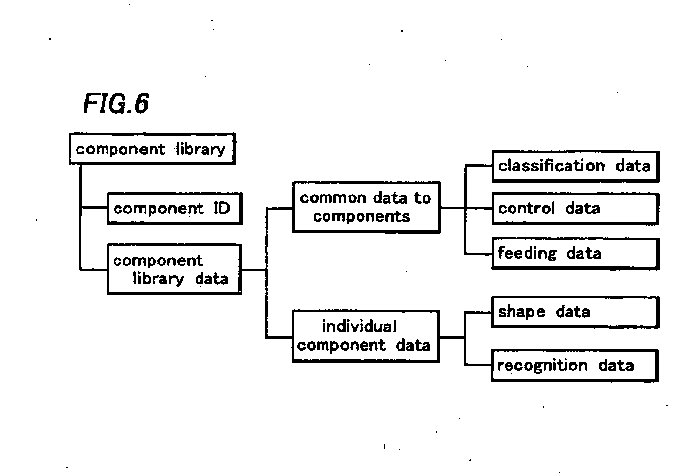

Next, an adjustment mode environment at a time when the picked-up component is recognized as improper in the "component recognition monitoring navigation mode" will be described hereafter. First, a structure of the component library is described before description of an adjustment mode environment. The component library has a "component ID" stored with names of each component data and "component library data" stored with information of each component, and its structure is shown in Fig. 6. The "component library data" has "common data to components" and "individual component data". The "common data to components" has "classification data", "control data", and "feeding data", and the "individual component data" has "shape data" and "recognition data". Data which is to be corrected by the adjustment for the component recognized as improper are the "shape data" and the "recognition data" in the "individual component data".

The "shape data" is used for identifying a component by classifying it into one of a lead-unattached and cylindrical component, a lead-unattached and square component, a lead-unattached and irregular shaped component (simple), a lead attached IC (simple), a lead attached IC (complex), a lead attached connector (simple), a lead attached connector (complex), an other lead attached component (simple), and an other lead attached component (complex). Each of the classifications further has data about a component size (in X and Y directions, a thickness), a corner (chamfered state), an edge (edge shape), a lead, and so on. The "recognition data" has data about an illuminating method (reflecting method, transmitting method), an illumination pattern of an illumination unit, a set permissible value of component size, a recognition processing level, a recognition algorithm, and so on.

The component library is used as a data base for controlling component data in order to define each of the components. Therefore, when correcting the data in the adjustment mode, data values in the "individual component data ("shape data" and "recognition data")" in the "component library data" formed in advance are not rewritten directly but adjusted in the following manner.

When the printed board type is changed, the apparatus 1 has original data of the component library and a dead copy of the original data (temporary data). The temporary data are used for actual manufacturing running and corrected in the adjustment mode. This enables correcting of various data when the component recognition navigation mode is activated as well as during a temporary halt of the apparatus 1.

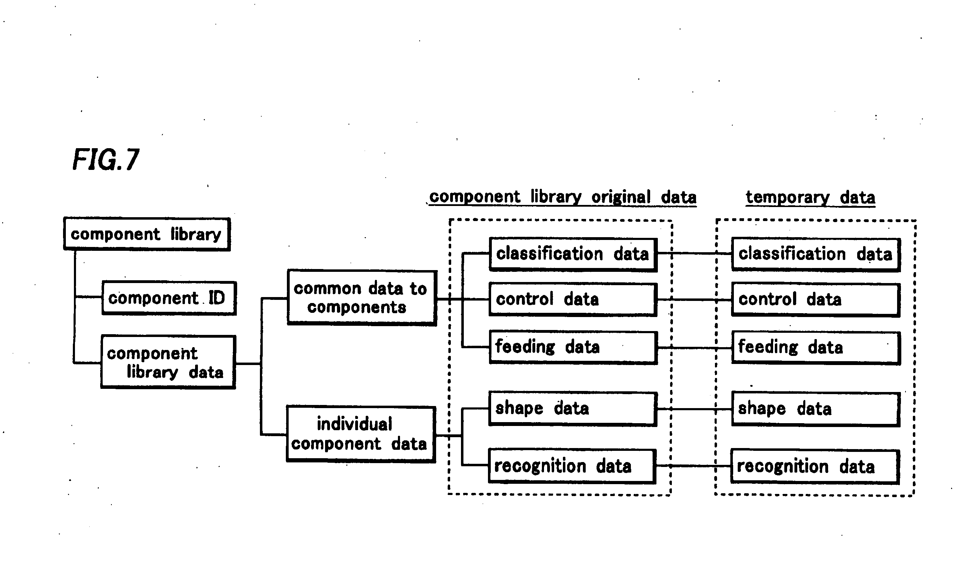

The data structured as above are controlled and operated in the following manner. The temporary data which has values different from values of the original data are automatically searched and additionally registered in a component library storage area using a new component ID. The progression of the correction of the temporary data can be checked by correction histories in the temporary data logged on a time series. A derivative registration of the new component ID are performed except when the apparatus 1 is in operation of component mounting on the printed board, in principle. According to the derivative registration, the temporary data which is corrected and used for running so far is replaced by the new component ID and its component data, and data for a printed board to be manufactured is updated. At this time, the original data and the dead copy data in the component library become the same, being initialized. Fig. 7 shows a structure of the described component library, showing a relation of the original data and the temporary data.

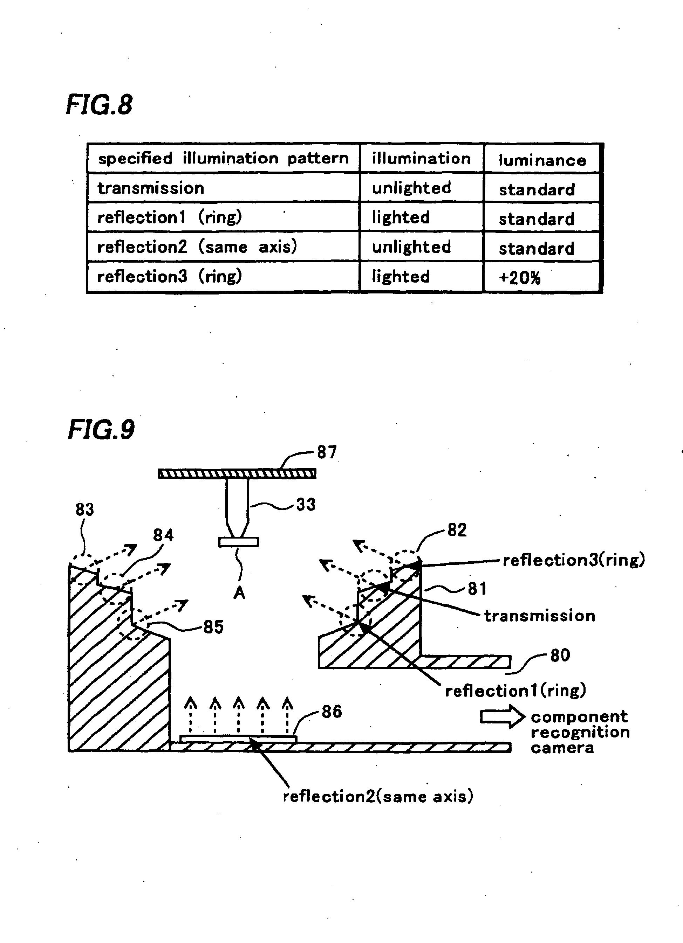

Next, an e example of an operating environment when shifted to the adjustment mode by activation of the "component recognition monitoring navigation mode". An illuminating condition adjustment environment will be described first. There are items of setting an "illumination pattern" and a "luminance" for setting an illuminating condition of each of the illumination units used for component recognition among items of the recognition data. Those items are data stored in the RAM 42 for setting an optimal illuminating condition (Fig. 8) corresponding to the degrees of light reflection of electrodes, leads, and molded resin, which are different among the components of various shapes or materials.

Next, an illuminating structure of Fig. 9 will be described. A saucer-shaped LED holder 81 includes openings 80 through which the component recognition camera 34 takes an image and many LEDs 82. The LEDs 82 are formed by vertically aligning LED arrays on a plurality of steps, the LED arrays being formed by annularly aligning LEDs in a horizontal direction. An illumination unit 83 on a highest step makes a " reflection 3 illumination pattern", an illumination unit 84 on a second highest step makes a "transmitting illumination pattern", and an illumination unit 85 on a third highest step makes a "reflection 1 illumination pattern", and an illumination unit 86 on a bottom of the LED holder 81 makes a "reflection 2 illumination pattern". A numeral 87 designates a diffusion plate provided with the suction nozzle 33. The diffusion plate 87 diffuses light emitted from the illumination unit 84 making the "transmitting illumination pattern", and the component recognition camera 34 takes an image of a transmission image of an electronic component A picked up by the suction nozzle 33. The CPU 40 controls illuminating or extinguishing of light of each of the illumination units 83, 84, 85, and 86 based on the data as shown in Fig. 8 set for forming an optimal illuminating condition for each of the electronic components A.

When the picked-up component can not be recognized properly because of an improper illuminating condition, the illuminating condition adjustment environment is used for changing the illumination pattern to an optimal illumination pattern for the component. In the example of the illuminating structure shown in Fig. 9, the optimal illuminating environment is formed by illuminating or extinguishing light and adjusting each luminance (-80 %, -70 %, ~, standard, +10%, +20 %, ~,) of each of the illumination units 83, 84, 85, and 86 independently provided for a respective use. At this time, for example, the luminance for properly taking a component image by the camera should be examined by checking the image actually taken with set luminance. Therefore, it is necessary to repeat checking of the taken image by manually changing each of the data until the luminance is decided. This procedure makes an operating efficiency reduced. To avoid this inconvenience, an automatic searching operation for an optimal luminance is used, although each of the data can be still manually correctedl.

When the operator selects any one of the illumination units 83, 84, 85, and 86, and selects either one of a "+ direction (luminance UP)" and a "- direction (luminance DOWN)", the CPU 40 automatically searches an optimal luminance in the selected direction with repeating taking of a component image. At this time, the component recognition test can be optionally linked to this operation. The operator can check whether a luminance searching direction is proper by monitoring the taken image of the component displayed on the CRT 55.

This luminance adjustment is performed by trial and error so that the original data values are kept the same in order to reset values to the original data whenever the luminance searching direction is found improper. When the luminance adjustment of the illumination patterns is completed and an environment where the component can be properly recognized is established, the illumination data are updated. As a result, the electronic components that have been initially judged as improper are rescued.

When receiving a command of utilizing the data adjusted by this adjustment operation for manufacturing running, the CPU 40 stores a date, a time, corrected data items, an operator's name, and so on in the RAM 42. In the subsequent manufacturing operation, information about a manufacturing control such as a proper recognition rate can be calculated in a time series in order to detect whether the adjusted data effectively improves the manufacturing operation, so that the operator can check running qualities.

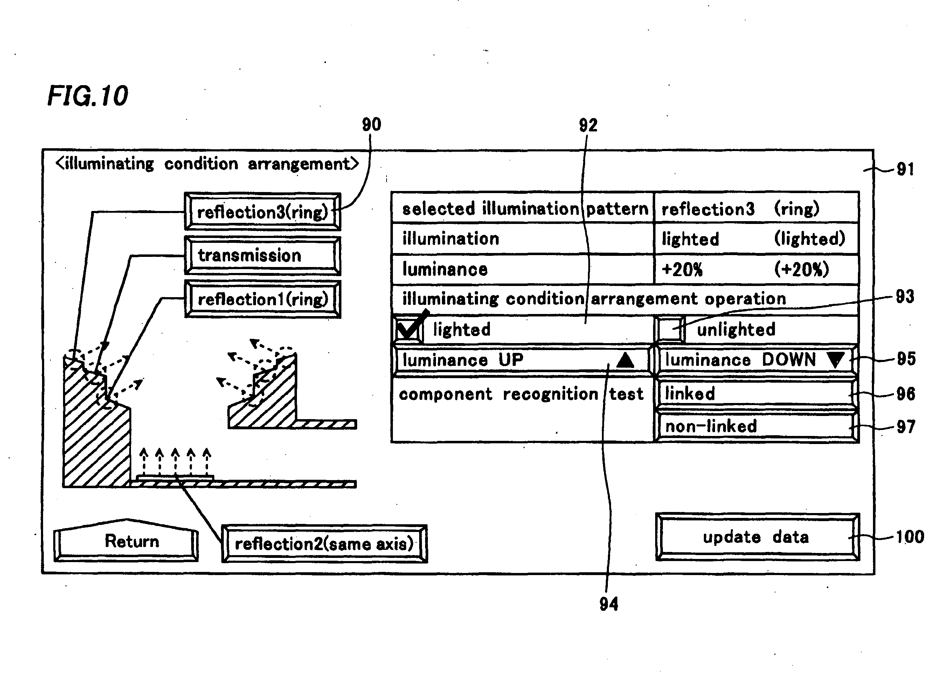

Next, an operation of the illuminating condition adjustment will be described based on an operation screen displayed on the CRT 55 as shown in Fig. 10. First, the operator selects the illumination unit to be adjusted among the illumination units 83, 84, 85, and 86. When the operator selects a "reflection 3 (ring)" switch 90, for example, set values of the original data of the "reflection 3" are displayed on a data display portion 91 on an upper right side. The displayed values include an illumination pattern and luminance, and the data or the numbers enclosed in parentheses are the values corrected in the adjustment environment. At first the displayed values which are not enclosed and the displayed values enclosed in parentheses are the same since the original data and the temporary data to be used for running are the same.

Switching of illuminating and extinguishing of light is performed by touching either selected one of switches 92 and 93. Luminance can be adjusted by a "luminance UP Δ" switch 94 and a "luminance DOWN ∇" 95. Either a linked operation or a non-linked operation of the component recognition test in the image-taking operation performed at the automatically set luminance can be selected by touching a "linked operation" switch 96 or a "non-linked operation" switch 97.

When the operator touches an execute switch 98 in the operation panel after completing the above settings, the operation starts. The CPU 40 controls the luminance increase or decrease in the specified direction from the luminance of the original data, and controls the component recognition camera 34 to sequentially take images of the components. The operator observes the recognized images displayed on the CRT 55 in order to check the progress. When the component recognition test is set linked and the components are recognized as proper, the operation automatically halts. The operation also automatically halts, when the luminance reaches an upper limit or a lower limit of the luminance range. Furthermore, for halting the operation forcibly, the operator touches a halt switch 99 of the operation panel.

When the adjustment of the proper illuminating condition is completed, the operator touches an "update data" switch 100 on a lower right side and then the "execute" switch 98 to rewrite the temporary data to be used for the manufacturing running by the adjusted data. Although there are other operation screens for directly correcting each of data values, for executing library informing, or for selecting an algorithm, the detail description is omitted here.

Hereafter, a mounting operation using the component recognition monitoring navigation mode and the illumination condition adjustment will be described. The feeding conveyer 4, the positioning portion 5, and the discharge conveyer 6 are replaced by others corresponding to the new type of the printed board. After changing to the printed board of the new type, a printed board P from the upstream device (not shown) is conveyed to the positioning portion 5 through the feeding conveyer 4, and positioned and fixed by the positioning device (not shown) of the positioning portion 5. After this positioning, the suction nozzles 33 selected corresponding to types of the electronic components A to be mounted sequentially pick the electronic components A up by suction from predetermined component feeding units 3, and mount the components A on the printed board P based on the mounting data stored in the RAM 42.

Before this mounting of each of the picked-up electronic components A, the Y axis motor 50 is driven to move the beam 30A in the Y direction along the pair of left and right guides 31, and the X axis motor 49 is driven to move the mounting head 32A in the X direction along guides, so that the suction nozzle 33 holding the electronic component A by suction moves to a position provided with the component recognition camera 34.

The component recognition camera 34 takes an image of the electronic component A by a transmission method or a reflection method. The electronic component A is illuminated by selected ones among the illumination units 83, 84, 85, and 86 according to the illuminating condition adjustment set for the electronic component A. The recognition processing device 53 performs the recognition processing on the image based on the component library data. That is, the recognition processing device 53 stores the taken image, recognizes a position of the electronic component A by recognizing a center position or slanting of the component A, and measures a shape and size of the component A to decide whether the measured component shape and size are within a range of permissible values.

When the component A , which is one of the first components picked up from the component feeding units 3 to be mounted on the printed board P, is recognized as proper, the CPU 40 detects whether or not the "all lane 1'st pickup monitoring mode" is set based on the data stored in the RAM 42. If that mode is set, the CPU 40 cancels the "all lane 1'st pickup monitoring mode" for the electronic component A.

Then, the electronic component A is mounted on the printed board P positioned at the positioning portion 5 based on the recognition result by the recognition processing device 53. At this time, shift amounts of the position and angle of the electronic component A held by the suction nozzle 33 from the proper position and angle are corrected by moving the suction nozzle 33 by the X axis motor 49, the Y axis motor 50 and the θ axis motor 51, and then the suction nozzle 33 descends driven by the vertical axis motor 52 to mount the electronic component A on the printed board P.

As described above, in the case where the electronic component A is recognized as proper and the "all lane 1'st pickup monitoring mode" is not set, the shift amount of the component position is corrected and then component A is mounted on the printed board P. Accordingly, the recognition processing and the mounting operation are performed to other electronic components A to be mounted on the printed board P by repeating the above steps until all the electronic components A are mounted on the first printed board P, according to the mounting data stored in the RAM 42.

Suppose that the electronic component A is recognized as improper, for example, an outer size of the component A is improper or the component A is not attached to the suction nozzle 33. In this case, the CPU 40 detects whether or not the "component recognition monitoring navigation mode" is set for the lane feeding the component A, based on the data stored in the RAM 42. If not set, the CPU 40 updates the control data, that is, stores the component ID of the electronic component A or a time of that recognition in the RAM 42, classifying it by factors in recognition of the component as improper, as data of components recognized as improper. Then, the CPU 40 makes the suction nozzle 33 discharge the electronic component A in the exhaust box (not shown), and executes the picking-up operation again (recovery operation) as well as stores the execution of the recovery operation in the RAM 42.

In a case where the electronic component A is recognized as improper and the CPU 40 detects that the "component recognition monitoring navigation mode" is set for the lane feeding the component A, that is, that the "all lane 1'st pickup monitoring mode" or the "specified lane monitoring mode" is set for the lane, the "component recognition monitoring navigation mode" is activated to move to the adjustment mode, and the operator decides whether or not the picked-up component A is to be discharged by visually examining the component recognition image displayed on the CRT 55.

When factors in recognition of the component A as improper such as lead flexure are obvious by the visual examination by the operator, the component A is discharged to repeat the picking-operation by the operator's decision. When the factors are not obvious and the operator decides that the component A should not be discharged, the illuminating condition is readjusted and the component library data is corrected.

That is, on the screen displayed on the CRT 55 as shown in Fig. 10, the operator corrects luminance data of the illumination units, a component size (in the X and Y directions, a thickness) in the "shape data" of the component library data, an illuminating method (reflection method, transmission method) of the "recognition data", illumination patterns of the illumination units, a permissive value of the component size, a recognition processing level, a recognition algorithm, and so on. Furthermore, after this correction, if linked, the component recognition test and library informing are performed. In the component recognition test, a standard luminance and the set luminance of the component image taken by the component recognition camera 34 by illuminating the component picked up by the suction nozzle 33 are compared to set a difference value between those luminance values within a predetermined value. In the library informing, the component recognition camera 34 takes an image of the electronic component A picked up by the suction nozzle 33, and recognition data of the image, such as the component shape, the size, and so on, are transferred to the electronic component mounting apparatus.

When the CPU 40 decides that the component A can be mounted because the component recognition resulting from the component recognition test and library informing is a "proper component" and decides that the monitoring mode (the "all lane 1'st pickup monitoring mode" or the "specified lane monitoring mode") can be cancelled for the lane feeding the component A, the monitoring mode for the lane is cancelled. Then, the shift amount of the component position is corrected, the component A is mounted on the printed board P, and the picking-up operation of a next electronic component is started. When the CPU 40 decides that the component A can not be mounted because the recognition result is an "improper component ", the CPU 40 updates the control data, that is, stores a component ID of the electronic component A or the time of that recognition in the RAM 42, classifying by factors in recognition of the component A as improper, as the data of components recognized as improper. Then, the CPU 40 makes the suction nozzle 33 discharge the electronic component A in the exhaust box (not shown), and executes the picking-up operation again (recovery operation) as well as stores the execution of the recovery operation in the RAM 42.

As described above, before the first electronic components picked up from the component feeding units are mounted on the first printed board P after the type of the printed board P is changed, if the picked-up component is recognized as an improper component, a component recognition test and a component library informing are performed for the picked-up real component, preventing a setting error of an illuminating condition, a forming error of the component library data, and so on. Therefore, the real component recognized as an improper component is not necessarily discharged immediately, and the time wasting for a halt of the component mounting apparatus can be reduced.

This embodiment employs the electronic component mounting apparatus of XY moving type in which the electronic component is mounted on the printed board, which is positioned and fixed, by moving the suction nozzle in the X and Y directions. However, the invention is not limited to this, but can employs an electronic component mounting apparatus of high-speed rotary table type in which the electronic component is mounted on the printed board positioned on a table which is movable in the X and Y directions.

Although particular preferred embodiments of the invention have been disclosed in detail, it will be recognized that variations or modifications of the disclosed apparatus, including the rearrangement of parts, are possible based on the disclosure and included within the scope of the present invention.

## Claims

1. An electronic component mounting apparatus mounting electronic components on a printed board (P), comprising:
- a plurality of component feeding units (3) feeding the electronic components;
- a suction nozzle (33) picking up one of the electronic components (A) from the component feeding units;
- an illumination device (83) illuminating the electronic component (A) picked up by the suction nozzle (33):
- a component recognition camera (34) taking an image of the illuminated electronic component (A);
- a recognition processing device (53) performing a recognition processing of the image of the electronic component (A) taken by the component recognition camera (34);
- an image display device (55); and
- a control device which requires the display (55) to display the image of the electronic component (A) taken by the component recognition camera (34) when the electronic component (A) is recognized to be improper based on a recognition processing result provided by the recognition processing device (53), changes an illuminating condition of the illumination devices (83) based on an instruction of an operator monitoring the displayed image, requires the component recognition camera (34) to take another image of the electronic component (A) picked up by the suction nozzle (33) for another recognition processing under the changed illuminating condition, and mounts the electronic component (A) on the printed board (P) when the electronic component is recognized to be proper after said another recognition processing.

2. An electronic component mounting apparatus mounting electronic components on a printed board (P), comprising:
- a plurality of component feeding units (3) feeding the electronic components;
- a suction nozzle (33) picking up one of the electronic components (A) from the component feeding units;
- an illumination device (83) illuminating the electronic component (A) picked up by the suction nozzle;
- a component recognition camera (34) taking an image of the illuminated electronic component (A) ;
- a recognition processing device (53) performing a recognition processing of the image of the electronic component (A) taken by the component recognition camera;
- an image display device (55); and
- a control device which requires the display to display the image of the electronic component (A) taken by the component recognition camera (34) when the electronic component (A) is recognized to be improper based on a recognition processing result provided by the recognition processing device (53), modifies component library data of the electronic component (A) based on an instruction of an operator monitoring the displayed image, requires the component recognition camera (34) to take another image of the electronic component (A) picked up by the suction nozzle (33) for another recognition processing using the modified component library data, and mounts the electronic component (A) on the printed board (P) when the electronic component (A) is recognized to be proper after said another recognition processing.

3. A method for mounting an electronic component, comprising:
- picking up the electronic component (A) from a component feeding unit (3) by a suction nozzle (33);
- illuminating the electronic component (A) picked up by the suction nozzle (33);
- taking an image of the illuminated electronic component (A) by a component recognition camera (34):
- performing a recognition processing of the image
- displaying the image when the electronic component (A) is recognized to be improper based on a result of the recognition processing performed on the image;
- changing an illuminating condition based on a decision by an operator monitoring the displayed image;
- taking another image of the electronic component under the changed illumination condition for another recognition processing; and
- mounting the electronic component (A) on a print board (P) when the electronic component (A) picked up by the suction nozzle (33) is recognized to be proper after said another recognition processing.

4. The method for mounting an electronic component of claim 3, wherein the electronic component (A) is an electronic component that is picked up first from the component feeding unit (3) when a series of mounting operations starts for a type of printed board (P).

5. The method for mounting an electronic component of claim 3, wherein the component feeding unit (3) comprises a plurality of units, and the electronic component (A) is each of electronic components that are picked up first from corresponding units (3) when a series of mounting operations starts for a type of printed board (P).

6. The method for mounting an electronic component of claim 3, wherein the component feeding unit (3) comprises a plurality of units that are disposed on corresponding feeder bases (3A, 3B, 3C, 3D), and the electronic component (A) is each of electronic components that are picked up first from corresponding units (3) that are disposed on a feeder base selected from the feeder bases (3A, 3B, 3C, 3D) when a series of mounting operations starts for a type of printed board (P).

7. A method for mounting an electronic component, comprising:
- picking up the electronic component (A) from a component feeding unit (3) by a suction nozzle (33):
- illuminating the electronic component picked up by the suction nozzle (33);
- taking an image of the illuminated electronic component (A) by a component recognition camera (34):
- displaying the image taken by the component recognition camera (34) when the electronic component (A) is recognized to be improper based on a recognition processing performed on the image taken by the component recognition camera (34);
- modifying component library data of the electronic component (A) in response to a decision by an operator monitoring the displayed image and
- mounting the electronic component on a print board (P) when the electronic component (A) picked up by the suction nozzle (33) is recognized to be proper based on another recognition processing performed using the modified component library data.

8. The method for mounting an electronic component of claim 7, wherein the electronic component (A) is an electronic component that is picked up first from the component feeding unit (3) when a series of mounting operations starts for a type of printed board (P).

9. The method for mounting an electronic component of claim 7, wherein the component feeding unit (3) comprises a.plurality of units, and the electronic component (A) is each of electronic components that are picked up first from corresponding units when a series of mounting operations starts for a type of printed board (P).

10. The method for mounting an electronic component of claim 7, wherein the component feeding unit (3) comprises a plurality of units that are disposed on corresponding feeder bases (3A, 3B, 3C, 3D), and the electronic component (A) is each of electronic components that are picked up first from corresponding units (3) that are disposed on a feeder base selected from the feeder bases (3A, 3B, 3C, 3D) when a series of mounting operations starts for a type of printed board (P).

## Patentansprüche

1. Elektronikkomponentenmontagevorrichtung, die Elektronikkomponenten auf einer Leiterplatte (P) montiert, umfassend:
- mehrere Komponentenzuführeinheiten (3), die die Elektronikkomponenten zuführen;
- eine Saugdüse (33), die eine der Elektronikkomponenten (A) von den Komponentenzuführeinheiten aufgreift;
- eine Beleuchtungseinrichtung (83), die die von der Saugdüse (33) aufgegriffene Elektronikkomponente (A) beleuchtet;
- eine Komponentenerkennungskamera (34), die ein Bild von der beleuchteten Elektronikkomponente (A) aufnimmt;
- eine Erkennungsverarbeitungseinrichtung (53), die eine Erkennungsverarbeitung des von der Komponentenerkennungskamera (34) aufgenommenen Bildes der Elektronikkomponente (A) durchführt;
- eine Bildanzeigeeinrichtung (55) und
- eine Steuereinrichtung, die die Anzeige (55) benötigt, um das von der Komponentenerkennungskamera (34) aufgenommene Bild der Elektronikkomponente (A) anzuzeigen, wenn die Elektronikkomponente (A) auf der Basis eines von der Erkennungsverarbeitungseinrichtung (53) gelieferten Erkennungsverarbeitungsergebnisses als falsch erkannt wird, eine Beleuchtungsbedingung der Beleuchtungseinrichtungen (83) auf der Basis einer Anweisung eines das angezeigte Bild überwachenden Operators ändert, erfordert, dass die Komponentenerkennungskamera (34) ein anderes Bild der von der Saugdüse (33) aufgegriffenen Elektronikkomponente (A) für eine andere Erkennungsverarbeitung unter der geänderten Beleuchtungshedingung aufnimmt, und die Elektronikkomponente (A) auf der Leiterplatte (P) montiert, wenn die Elektronikkomponente nach der anderen Erkennungsverarbeitung als richtig erkannt wird.

2. Elektronikkomponentenmontagevorrichtung, die Elektronikkomponenten auf einer Leiterplatte (P) montiert, umfassend:
- mehrere Komponentenzuführeinheiten (3), die die Elektronikkomponenten zuführen;
- eine Saugdüse (33), die eine der Elektronikkomponenten (A) von den Komponentenzufuhreinheiten aufgreift;
- eine Beleuchtungseinrichtung (83), die die von der Saugdüse (33) aufgegriffene Elektronikkomponente (A) beleuchtet;
- eine Komponentenerkennungskamera (34), die ein Bild von der beleuchteten Elektronikkomponente (A) aufnimmt;
- eine Erkennungsverarbeitungseinrichtung (53), die eine Erkennungsverarbeitung des von der Komponentenerkennungskamera (34) aufgenommenen Bildes der Elektronikkomponente (A) durchführt;
- eine Bildanzeigeeinrichtung (55) und
- eine Steuereinrichtung, die die Anzeige benötigt, um das von der Komponentenerkennungskamera (34) aufgenommene Bild der Elektronikkomponente (A) anzuzeigen, wenn die Elektronikkomponente (A) auf der Basis eines von der Erkennungsverarbeitungseinrichtung (53) gelieferten Erkennungsverarbeitungsergebnisses als falsch erkannt wird, die Komponentenbibliotheksdaten der Elektronikkomponente (A) auf der Basis einer Anweisung eines das angezeigte Bild überwachenden Operators modifiziert, erfordert, dass die Komponentenerkennungskamera (34) ein anderes Bild der von der Saugdüse (33) aufgegriffenen Elektronikkomponente (A) für eine andere Erkennungsverarbeitung unter Verwendung der modifizierten Komponentenbibliotheksdaten aufnimmt, und die Elektronikkomponente (A) auf der Leiterplatte (P) montiert, wenn die Elektronik-komponente nach der anderen Erkennungsverarbeitung als richtig erkannt wird.

3. Verfahren zum Montieren einer Elektronikkomponente, umfassend:
- Aufgreifen der Elektronikkomponente (A) von einer Komponentenzuführeinheit (3) durch eine Saugdüse (33);
- Beleuchten der von der Saugdüse (33) aufgegriffenen Elektronikkomponente (A);
- Aufnehmen eines Bildes der beleuchteten Elektronikkomponente (A) durch eine Komponentenerkennungskamera (34);
- Durchführen einer Erkennungsverarbeitung des Bildes;
- Anzeigen des Bildes, wenn die Elektronikkomponente (A) auf der Basis eines Ergebnisses der an dem Bild durchgeführten Erkennungsverarbeitung als falsch erkannt wird;
- Ändern einer Beleuchtungsbedingung auf der Basis einer Entscheidung durch einen das angezeigte Bild überwachenden Operator;
- Aufnehmen eines weiteren Bildes der Elektronikkomponente unter der geänderten Beleuchtungsbedingung für eine weitere Erkennungsverarbeitung und
- Montieren der Elektronikkomponente (A) auf einer Leiterplatte (P), wenn die von der Saugdüse (33) aufgegriffene Elektronikkomponente (A) nach der weiteren Erkennungsverarbeitung als richtig erkannt wird.

4. Verfahren zum Montieren einer Elektronikkomponente nach Anspruch 3, wobei die Elektronikkomponente (A) eine Elektronikkomponente ist, die zuerst von der Komponentenzuführeinheit (3) aufgegriffen wird, wenn eine Serie von Montageoperationen für einen Typ von Leiterplatte (P) beginnt.

5. Verfahren zum Montieren einer Elektronikkomponente nach Anspruch 3, wobei die Komponentenzuführeinheit (3) mehrere Einheiten umfasst und die Elektronikkomponente (A) jede von Elektronikkomponenten ist, die zuerst von entsprechenden Einheiten (3) aufgegriffen werden, wenn eine Serie von Montageoperationen für einen Typ von Leiterplatte (P) beginnt.

6. Verfahren zum Montieren einer Elektronikkomponente nach Anspruch 3, wobei die Komponentenzuführeinheit (3) mehrere Einheiten umfasst, die auf entsprechenden Zuführbasen (3A, 3B, 3C, 3D) angeordnet sind, und die Elektronikkomponente (A) jede von Elektronikkomponenten ist, die zuerst von entsprechenden Einheiten (3) aufgegriffen werden, die auf einer unter den Zuführbasen (3A, 3B, 3C, 3D) ausgewählten Zuführbasis angeordnet sind, wenn eine Serie von Montageoperationen für einen Typ von Leiterplatte (P) beginnt.

7. Verfahren zum Montieren einer Elektronikkomponente, umfassend:
- Aufgreifen der Elektronikkomponente (A) von einer Komponentenzuführeinheit (3) durch eine Saugdüse (33);
- Beleuchten der von der Saugdüse (33) aufgegriffenen Elektronikkomponente;
- Aufnehmen eines Bildes der beleuchteten Elektronikkomponente (A) durch eine Komponentenerkennungskamera (34);
- Anzeigen des von der Komponentenerkennungskamera (34) aufgenommenen Bildes, wenn die Elektronikkomponente (A) auf der Basis einer an dem von der Komponentenerkennungskamera (34) aufgenommenen Bildes durchgeführten Erkennungsverarbeitung als falsch erkannt wird;
- Modifizieren von Komponentenbibliotheksdaten der Elektronikkomponente (A) als Reaktion auf eine Entscheidung durch einen das angezeigte Bild überwachenden Operator; und
- Montieren der Elektronikkomponente auf einer Leiterplatte (P), wenn die von der Saugdüse (33) aufgegriffene Elektronikkomponente (A) auf der Basis einer anderen, unter Verwendung der modifizierten Komponentenbibliotheksdaten durchgeführten Erkennungsverarbeitung als richtig erkannt wird.

8. Verfahren zum Montieren einer Elektronikkomponente nach Anspruch 7, wobei die Elektronikkomponente (A) eine Elektronikkomponente ist, die zuerst von der Komponentenzuführeinheit (3) aufgegriffen wird, wenn eine Serie von Montageoperationen für einen Typ von Leiterplatte (P) beginnt.

9. Verfahren zum Montieren einer Elektronikkomponente nach Anspruch 7, wobei die Komponentenzuführeinheit (3) mehrere Einheiten umfasst und die Elektronikkomponente (A) jede von Elektronikkomponenten ist, die zuerst von entsprechenden Einheiten aufgegriffen werden, wenn eine Serie von Montageoperationen für einen Typ von Leiterplatte (P) beginnt.

10. Verfahren zum Montieren einer Elektronikkomponente nach Anspruch 7, wobei die Komponentenzuführeinheit (3) mehrere Einheiten umfasst, die auf entsprechenden Zuführbasen (3A, 3B, 3C, 3D) angeordnet sind und die Elektronikkomponente (A) jede von Elektronikkomponenten ist, die zuerst von entsprechenden Einheiten (3) aufgegriffen werden, die auf einer unter den Zuführbasen (3A, 3B, 3C, 3D) ausgewählten Zuführbasis angeordnet sind, wenn eine Serie von Montageoperationen für einen Typ von Leiterplatte (P) beginnt.

## Revendications

1. Appareil de montage de composants électroniques destiné à monter des composants électroniques sur une carte de circuit imprimé (P), comprenant :
- une pluralité d'unités de distribution de composants (3) distribuant les composants électroniques ;
- une buse de succion (33) prélevant un des composants électroniques (A) des unités de distribution de composants ;
- un dispositif d'éclairage (83) éclairant le composant électronique (A) prélevé par la buse de succion (33) ;
- une caméra de reconnaissance de composant (34) prenant une image du composant électronique éclairé (A) ;
- un dispositif de traitement de reconnaissance (53) effectuant un traitement de reconnaissance de l'image du composant électronique (A) prise par la caméra de reconnaissance de composant (34) ;
- un dispositif d'affichage d'image (55) ; et
- un dispositif de commande qui demande au dispositif d'affichage (55) d'afficher l'image du composant électronique (A) prise par la caméra de reconnaissance de composant (34) lorsque le composant électronique (A) est reconnu ne pas être le composant correct sur la base d'un résultat du traitement de reconnaissance fourni par le dispositif de traitement de reconnaissance (53), change une condition d'éclairage du dispositif d'éclairage (83) sur la base d'une instruction d'un opérateur surveillant l'image affichée, demande à la caméra de reconnaissance de composant (34) de prendre une autre image du composant électronique (A) prélevé par la buse de succion (33) en vue d'un autre traitement de reconnaissance avec la condition d'éclairage changée, et monte le composant électronique (A) sur la carte de circuit imprimé (P) lorsque le composant électronique est reconnu être le composant correct après ledit autre traitement de reconnaissance.

2. Appareil de montage de composants électroniques destiné à monter des composants électroniques sur une carte de circuit imprimé (P), comprenant :
- une pluralité d'unités de distribution de composants (3) distribuant les composants électroniques ;
- une buse de succion (33) prélevant un des composants électroniques (A) des unités de distribution de composants ;
- un dispositif d'éclairage (83) éclairant le composant électronique (A) prélevé par la buse de succion ;
- une caméra de reconnaissance de composant (34) prenant une image du composant électronique éclairé (A) ;
- un dispositif de traitement de reconnaissance (53) effectuant un traitement de reconnaissance de l'image du composant électronique (A) prise par la caméra de reconnaissance de composant ;
- un dispositif d'affichage d'image (55) ; et
- un dispositif de commande qui demande au dispositif d'affichage d'afficher l'image du composant électronique (A) prise par la caméra de reconnaissance de composant (34) lorsque le composant électronique (A) est reconnu ne pas être le composant correct sur la base d'un résultat du traitement de reconnaissance fourni par le dispositif de traitement de reconnaissance (53), modifie les données de la bibliothèque de composants du composant électronique (A) sur la base d'une instruction d'un opérateur surveillant l'image affichée, demande à la caméra de reconnaissance de composant (34) de prendre une autre image du composant électronique (A) prélevé par la buse de succion (33) en vue d'un autre traitement de reconnaissance à l'aide des données modifiées de la bibliothèque de composants, et monte le composant électronique (A) sur la carte de circuit imprimé (P) lorsque le composant électronique (A) est reconnu être le composant correct après ledit autre traitement de reconnaissance.

3. Procédé de montage d'un composant électronique, consistant à :
- prélever le composant électronique (A) d'une unité de distribution de composants (3) par une buse de succion (33) ;
- éclairer le composant électronique (A) prélevé par la buse de succion (33) ;
- prendre une image du composant électronique éclairé (A) par une caméra de reconnaissance de composant (34) ;
- effectuer un traitement de reconnaissance de l'image ;
- afficher l'image lorsque le composant électronique (A) est reconnu ne pas être le composant correct sur la base d'un résultat du traitement de reconnaissance effectué sur l'image ;
- changer une condition d'éclairage sur la base d'une décision prise par un opérateur surveillant l'image affichée;
- prendre une autre image du composant électronique avec la condition d'éclairage changée en vue d'un autre traitement de reconnaissance ;
et
- monter le composant électronique (A) sur une carte de circuit imprimé (P) lorsque le composant électronique (A) prélevé par la buse de succion (33) est reconnu être le composant correct après ledit autre traitement de reconnaissance.

4. Procédé de montage d'un composant électronique selon la revendication 3, dans lequel le composant électronique (A) est un composant électronique qui est prélevé d'abord de l'unité de distribution de composants (3) lorsqu'une série d'opérations de montage démarre pour un type de carte de circuit imprimé (P).

5. Procédé de montage d'un composant électronique selon la revendication 3, dans lequel l'unité de distribution de composants (3) comprend une pluralité d'unités, et le composant électronique (A) est à chaque fois un des composants électroniques qui sont prélevés d'abord par des unités correspondantes (3) lorsqu'une série d'opérations de montage démarre pour un type de carte de circuit imprimé (P).

6. Procédé de montage d'un composant électronique selon la revendication 3, dans lequel l'unité de distribution de composants (3) comprend une pluralité d'unités qui sont disposées sur des bases de distribution correspondantes (3A, 3B, 3C, 3D), et le composant électronique (A) est à chaque fois un des composants électroniques qui sont prélevés d'abord des unités correspondantes (3) qui sont disposées sur une base de distribution sélectionnée parmi les bases de distribution (3A, 3B, 3C, 3D) lorsqu'une série d'opérations de montage démarre pour un type de carte de circuit imprimé (P).

7. Procédé de montage d'un composant électronique, consistant à :
- prélever le composant électronique (A) d'une unité de distribution de composants (3) par une buse de succion (33) ;
- éclairer le composant électronique prélevé par la buse de succion (33) ;
- prendre une image du composant électronique éclairé (A) par une caméra de reconnaissance de composant (34) ;
- afficher l'image prise par la caméra de reconnaissance de composant (34) lorsque le composant électronique (A) est reconnu ne pas être le composant correct sur la base d'un traitement de reconnaissance effectué sur l'image prise par la caméra de reconnaissance de composant (34) ;
- modifier des données de la bibliothèque de composants du composant électronique (A) en réponse à une décision prise par un opérateur surveillant l'image affichée ; et
- monter le composant électronique sur une carte de circuit imprimé (P) lorsque le composant électronique (A) prélevé par la buse de succion (33) est reconnu être le composant correct sur la base d'un autre traitement de reconnaissance effectué à l'aide des données modifiées de la bibliothèque de composants.

8. Procédé de montage d'un composant électronique selon la revendication 7, dans lequel le composant électronique (A) est un composant électronique qui est prélevé d'abord de l'unité de distribution de composants (3) lorsqu'une série d'opérations de montage démarre pour un type de carte de circuit imprimé (P).

9. Procédé de montage d'un composant électronique selon la revendication 7, dans lequel l'unité de distribution de composants (3) comprend une pluralité d'unités, et le composant électronique (A) est à chaque fois un des composants électroniques qui sont prélevés d'abord d'unités correspondantes lorsqu'une série d'opérations de montage démarre pour un type de carte de circuit imprimé (P).

10. Procédé de montage d'un composant électronique selon la revendication 7, dans lequel l'unité de distribution de composants (3) comprend une pluralité d'unités qui sont disposées sur des bases de distribution correspondantes (3A, 3B, 3C, 3D), et le composant électronique (A) est à chaque fois un des composants électroniques qui sont prélevés d'abord d'unités correspondantes (3) qui sont disposées sur une base de distribution sélectionnée parmi les bases de distribution (3A, 3B, 3C, 3D) lorsqu'une série d'opérations de montage démarre pour un type de carte de circuit imprimé (P).
